# EUROPEAN PATENT APPLICATION

(11) **EP 1 587 353 A1**
(43) Date of publication of application: **19.10.2005**
(21) Application number: 04076116.5
(22) Date of filing: 16.04.2004
(51) Int. Cl.: H05K 9/00

(54) **Shielding material for preventing outleakage of electromagnetic waves**

(71) Applicant: Hou, PonWei, Hsin-Chu City (TW)
(72) Inventor: Hou, PonWei, Hsin-Chu City (TW)
(74) Representative: Gillam, Francis Cyril

(57) **Abstract**

A shielding cover for reducing or preventing the outleakage of electromagnetic waves is adapted for shielding electrical products or electrical parts, tracks and connecting wires of electrical products. The shielding cover comprises an energy transference unit, possibly with an additional shielding unit for cooperation with the energy transference unit. The energy transference unit includes an insulated composition containing iron powder and natural or silicone rubber, and further components selected from zinc oxide, magnesium oxide, ethylene thiourea, and stearic acid, which are mixed by proportional weight to maximize energy transference over a given frequency range. The energy transference unit is provided at one side or at more than one side of the electrical product, or the electrical parts, tracks and connecting wires of the electrical product to be shielded for limiting radiation of electromagnetic waves and transferring the electromagnetic energy to heat energy, thereby reducing the radiation of electromagnetic waves, and accordingly protecting electrical products, the environment and human beings from the effects of radiated electromagnetic waves.

## Description

### BACKGROUND OF THE INVENTION

### 1. FIELD OF THE INVENTION

The present invention relates to a shielding cover for reducing or preventing outleakage of electromagnetic waves, and particularly to a shielding cover adapted to transfer electromagnetic energy radiated from electrical products and parts, tracks and connecting wires of electrical products to heat energy, thereby at least reducing or preventing outleakage of electromagnetic waves.

### 2. RELATED ART

Electrical products, electrical parts, tracks and connecting wires tend to produce radiated electromagnetic waves, which not only leads to abnormal working of the electrical products, but also contaminates environment and may even injure the human beings. On the other hand, in the information age, electrical products in pursuit of miniaturisation and high-speed transmission, make the radiation effect of electromagnetic waves more serious.

Electrical parts in the electrical products, such as a clock generator, integrated circuit (IC) central processing unit (CPU) etc, often form electric loops when running, and so are apt to produce electromagnetic waves. Moreover, conducting tracks and connecting wires of the electrical products may always produce electromagnetic waves. The antenna effect, namely the radiation effect of electromagnetic waves, is subject to length and the surrounding area of the tracks. In addition, it is important that one cannot use a personal computer in an airplane, because electromagnetic waves may be generated by computer during operation and might influence the electrical systems of the airplane, thereby resulting in danger for the flight of the airplane.

Conductive materials, for example, copper foil, aluminum foil, short-woven metal wires etc, are commonly used to shield electromagnetic waves. The inductance effect, for instance by using a ferrite core, is also employed to overcome this problem. Additionally, the capacitance effect, for example by adding bypass capacitors or by changing antenna length, has been tried to reduce the radiation of electromagnetic waves.

However, the above methods can not overcome the problem in substance. According to conservation of energy, electromagnetic waves may be masked at some parts of the electrical products, but at the same time the electromagnetic waves may move to another part. Similarly, the radiation effect of electromagnetic waves at certain frequencies of the electrical products may be masked, but at the same time radiation waves at another frequency may occur. Thus, the conventional methods cannot overcome the problem of the radiation effect of electromagnetic waves.

### SUMMARY OF THE INVENTION

Accordingly, an object of the present invention is to provide a shielding cover which transfers electromagnetic energy to heat energy, thereby reducing the radiation of electromagnetic waves from electrical products and perhaps wholly preventing the outleakage of electromagnetic waves, thereby protecting electrical products, the environment and human beings from the radiation effect of electromagnetic waves.

A shielding cover for at least reducing the outleakage of electromagnetic waves comprises an energy transference unit, which includes insulated compositions for surrounding those portions of electrical products, from which electromagnetic waves emanate, for transferring the electromagnetic energy to heat energy thereby reducing the radiation of electromagnetic waves and releasing the heat energy.

The insulated composition comprises iron powder and natural or silicon rubber, together with further components selected from zinc oxide, magnesium oxide, ethylene thiourea, and stearic acid, which are mixed complying with proportional weights in order to maximize energy transference for a given range of frequencies.

The shielding cover for reducing or preventing outleakage of electromagnetic waves may further comprise a shielding unit which cooperates with the energy transference unit and locates at one side or more than one side of an electrical product to be shielded, or at one side or more than one side of the electrical parts, tracks and connecting wires of the electrical product to be shielded, thereby limiting the radiation of electromagnetic waves by energy transference.

### BRIEF DESCRIPTION OF THE DRAWINGS

By way of example only, this invention will now be described in greater detail, with reference to the drawings.

Fig. 1 is a microwave characteristic chart of a shielding cover of the present invention, wherein electromagnetic waves from mobile phones (S frequency band of 2-4 GHz) is used as the object of the experiment; and

Figs. 2-5 are microwave characteristic charts of the shielding cover of the present invention, wherein electromagnetic waves at different frequency bands are used as objects of the experiments.

### DESCRIPTION OF THE PREFERRED EMBODIMENTS

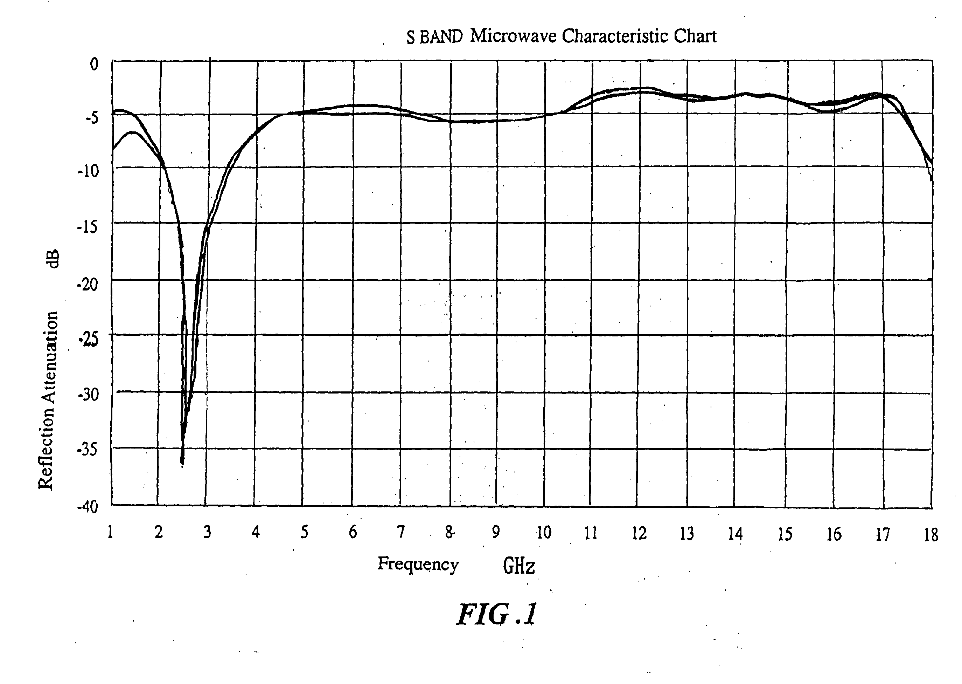

With reference to Fig. 1, a shielding cover for preventing outleakage of electromagnetic waves comprises an energy transference unit or a shielding unit for cooperating with the energy transference unit. The energy transference unit comprises an insulated composition selected from iron powder, natural or silicone rubber, zinc oxide, magnesium oxide, ethylene thiourea, and stearic acid etc, which are mixed complying with proportional weight to maximize energy transference.

The iron powder and the natural or silicone rubber make up 90% by weight of the insulated composition. The iron powder (e.g. available from Fluka Inc., Switzerland) has a particle diameter of 1-10µ, density of 1-10g/ml, and is present in the range of 30-85% by weight. The natural or silicone rubber (e.g. available from Du Pont Inc., US) is present in the composition in the range of 5-60% by weight. The zinc oxide and the magnesium oxide respectively are present in the range of 1-3% by weight, each. The ethylene thiourea and the stearic acid respectively are present in the range of 1-5% by weight, each. The blend of the insulated composition is heated for about 30 minutes at temperature of about 165° centigrade to become a hard sheet with a thickness of 0.1 to 10 mm and a size of 30 x 30 cm. The insulated composition and the shielding unit are placed around electromagnetic wave radiating portions of electrical products, and electrical parts, tracks and connecting wires of the electrical products. Depending upon the radiating direction of the electromagnetic waves, the electromagnetic wave energy transference unit may be at one side, at more than one side or around and / or cover the periphery of the electrical parts, tracks and connecting wires. The energy transference unit may be made as a sponge-like material, by a different process.

The electromagnetic waves from the electrical products, or from the electrical parts, tracks and connecting wires of the electrical products, are limited thereby, and are transferred to heat energy. Thus, there will be little leakage of electromagnetic waves. The temperature rise from the heat is lower than 1° centigrade.

Referring to Fig. 1, the experimental objects are electromagnetic waves emitted by a mobile phone. Coordinate X represents the electromagnetic wave frequency (GHz), and coordinate Y represents reflection attenuation (db). The experiment proves that the electromagnetic wave energy can be transferred to heat energy, giving a of 1° centigrade temperature rise, which neither damages the electrical products nor pollutes the environment.

A second shielding unit may be added to enhance the transference capability of the energy transference unit. The second shielding unit may be a metal sheet, such as of gold, silver, copper, iron, aluminum, platinum, stainless steel, an alloy, or an electromagnetic wave shielding film that is not grounded.

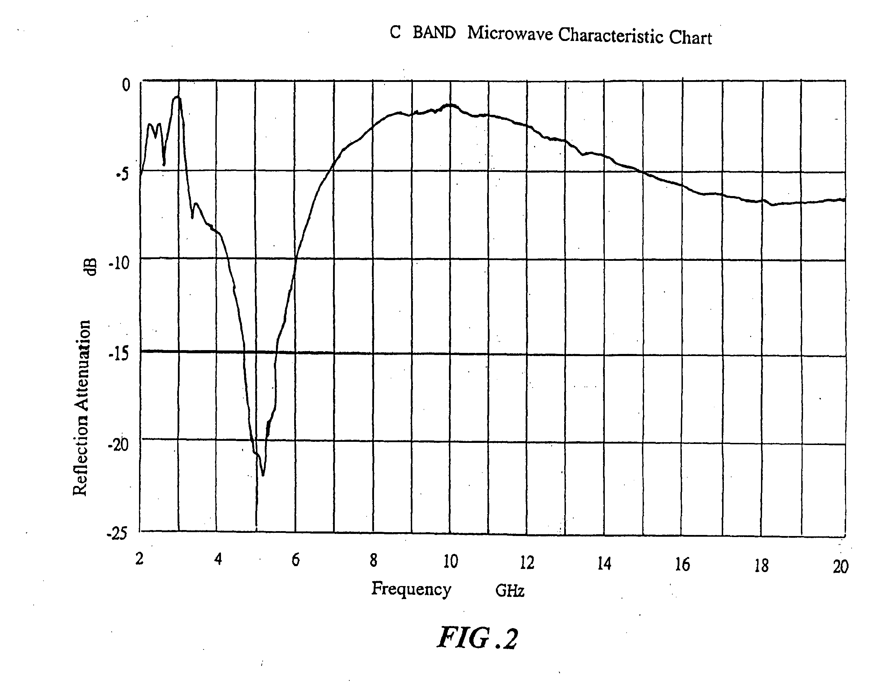

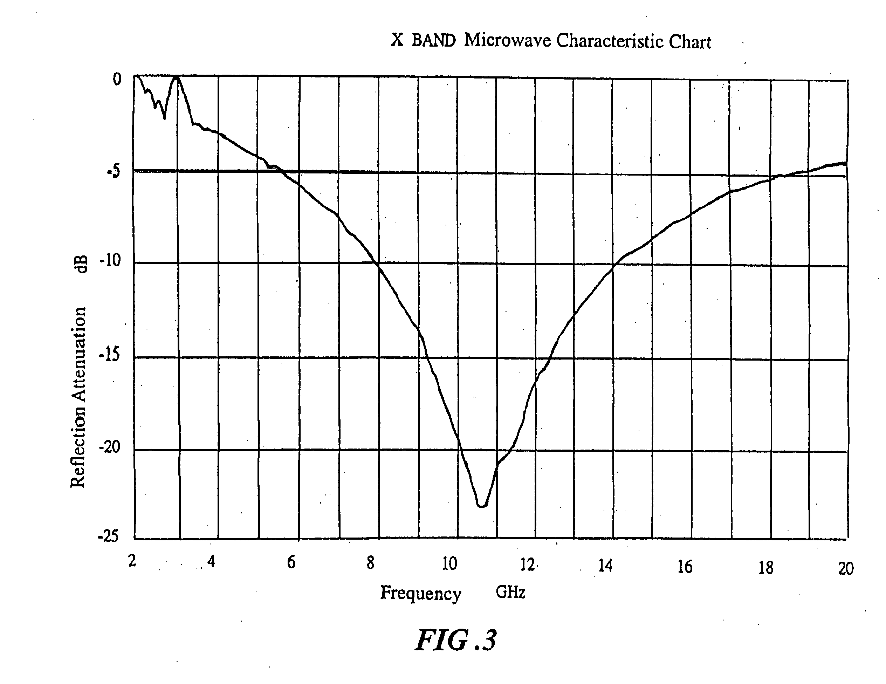

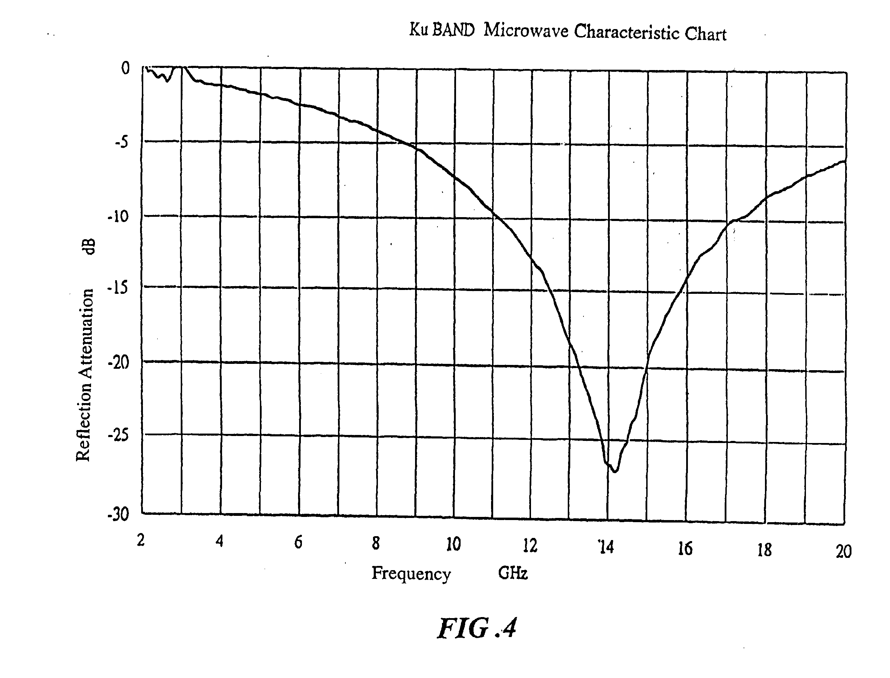

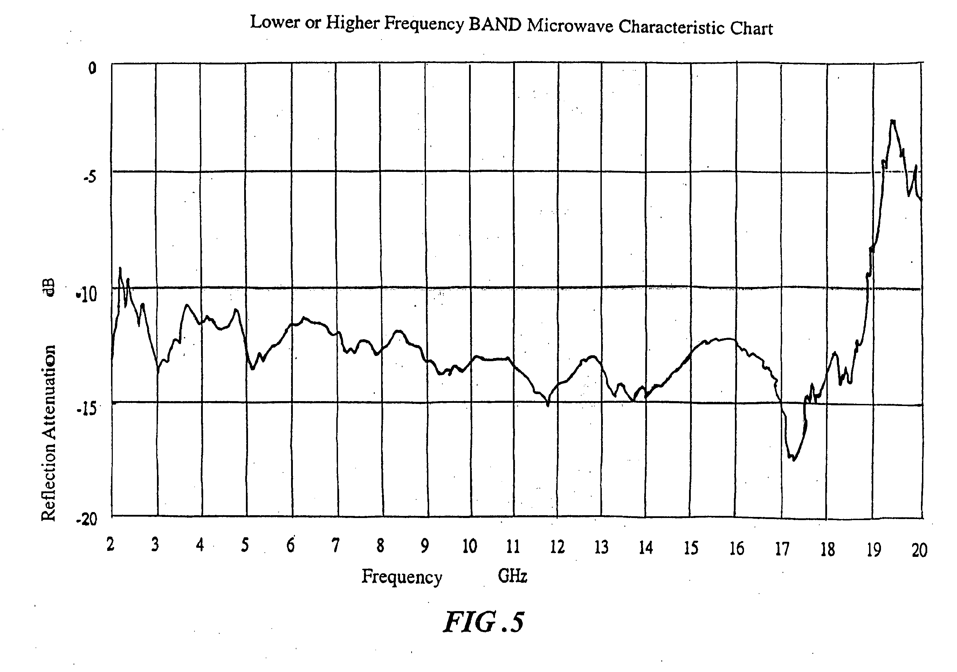

Referring to Figs. 2-5, the experimental objects are electromagnetic waves emitted at different frequencies. Coordinate X represents the electromagnetic wave frequency (GHz), and coordinate Y represents reflection attenuation (db). Fig. 2 shows the experiment result at the C frequency band in a range of 4-7 GHz; Fig. 3 shows the experiment result at the X frequency band in a range of 8-12 GHz; Fig. 4 shows the experiment result at the Ku frequency band in a range of 12-18 GHz; Fig. 5 shows the experiment result at lower or higher frequency bands. The experiments all prove that the electromagnetic wave energy can be transferred to heat energy giving a temperature rise of about 1° centigrade, which neither damages the electrical products nor pollutes the environment.

On the other hand, the number of the energy transference units may vary to adapt for different frequency bands of electromagnetic waves. For example, more energy transference units may be provided to cover a wider frequency band of electromagnetic waves.

It is understood that the invention may be embodied in other forms without departing from the scope thereof as defined by the claims. Thus, the present examples and embodiments are to be considered in all respects as illustrative and not restrictive, and the invention is not to be limited to the details given herein.

## Claims

1. A shielding cover for use as an energy transference unit to reduce or prevent outleakage of electromagnetic waves from electrical products and electrical parts, tracks and connecting wires of electrical products shielded by the energy transference unit, which cover comprises an insulated composition containing iron powder and natural or silicone rubber, and further components selected from zinc oxide, magnesium oxide, ethylene thiourea, and stearic acid, the components of the insulated composition being selected to maximize the conversion of electro-magnetic energy over a given frequency range to heat energy.

2. The shielding cover as claimed in claim 1, wherein the iron powder and the natural or silicone rubber together comprise 50 to 90% by weight of the insulated composition.

3. The shielding cover as claimed in claim 1 or claim 2, wherein the iron powder has a particle diameter of 1-10µ, a density of 1-10g/ml and comprises 30 to 85% by weight of the composition and wherein the natural or silicone rubber comprises 5 to 60% by weight of the composition.

4. The shielding cover as claimed in any of the preceding claims, wherein when present, each of the zinc oxide and the magnesium oxide respectively comprises 0.5 to 1.5% by weight of the composition.

5. The shielding cover as claimed in any of the preceding claims, wherein when present, each of the ethylene thiourea and the stearic acid respectively comprises 1 to 5% by weight of the composition.

6. The shielding cover as claimed in any of the preceding claims and forming a part of a shielding unit, wherein the shielding unit is adapted to be provided at one side or at more than one side of the electrical products, electrical parts, tracks and connecting wires of the electrical products with which the shielding unit is to be used.

7. The shielding cover as claimed in any of claims 1 to 5, and forming a part of an energy transference unit, wherein the energy transference unit is adapted to be provided at one side or at more than one side of the electrical products, electrical parts, traces and connecting lines of the electrical products with which the unit is to be used.

8. The shielding cover as claimed in any of the preceding claims, wherein the insulated composition is formed either as a hard sheet or as a sponge-like material.

9. The shielding cover as claimed in any of the preceding claims, wherein there is provided a second shielding unit to enhance the transference capability of the energy transference unit.

10. The shielding cover as claimed in claim 9, wherein the second shielding unit comprises a metal sheet, such as of gold, silver, copper, iron, aluminum, platinum, stainless steel or an alloy.

11. The shielding cover as claimed in claim 9 or claim 10, wherein the second shielding unit is an electromagnetic wave shielding film that is not grounded.

12. The shielding cover as claimed in claim 1, wherein more than one energy transference unit is provided to give shielding from electromagnetic waves over a wider frequency band.

13. A shielding process for reducing or preventing outleakage of electromagnetic waves from electrical products and electrical parts, tracks and connecting wires of electrical products, and comprising: a) providing an energy transference unit including an insulated composition containing iron powder and natural or silicone rubber, and further containing components selected from zinc oxide, magnesium oxide, ethylene thiourea, and stearic acid and which are mixed by proportional weight to maximize energy transference over a given frequency range; b) providing a shielding unit for cooperation with the energy transference unit; and c) arranging the energy transference unit at one side or at more than one side of the electrical products or electrical parts, tracks and connecting wires of the electrical products, or cooperating with the shielding unit to limit the radiation of electromagnetic waves and to transfer the electromagnetic energy to heat energy.
